# DEMANDE DE BREVET EUROPEEN

(11) **EP 1 091 425 A2**
(43) Date de publication de la demande: **11.04.2001**
(21) Numéro de dépôt: 00203241.5
(22) Date de dépôt: 15.09.2000
(51) Int. Cl.: H01L 43/06

(54) **Capteur à effet Hall et circuit intégré comprenant un tel capteur**

(30) Priorité: 08.10.1999 FR 9912667
(71) Demandeur: SCHLUMBERGER INDUSTRIES S.A., 92120 Montrouge (FR)
(72) Inventeur: Suski, Jan, 92160 Anthony (FR); Mosser, Vincent, 92350 Le Plessis Robinson (FR); Nouaze, Véronique, 92350 Le Plessis Robinson (FR)
(74) Mandataire: Montelmacher, Pascal M.

(57) **Abrégé**

Capteur à effet Hall (1) comprenant une couche d'isolation en SiO₂ (12) et une couche active mince (14) en Si présentant une épaisseur inférieure à 100 nm et recouvrant la couche d'isolation (12). La couche active (14) est recouverte par une couche diélectrique isolante (16). Ce capteur peut être intégré sur un circuit comportant aussi les composants semi-conducteurs adaptés à son fonctionnement et au traitement du signal de mesure qu'il délivre. Application au comptage de la consommation d'électricité.

## Description

La présente invention se rapporte à un capteur à effet Hall et à un circuit intégré comportant un tel capteur. Elle s'applique notamment au domaine du comptage de la consommation électrique.

On connaît des capteurs à effet Hall réalisés à partir d'un substrat en silicium de conductivité par exemple de type p sur lequel repose une couche active en silicium de conductivité de type n.

Deux paires d'électrodes sont en contact avec la couche active. Les électrodes de la première paire, dites "électrodes d'alimentation" disposées à deux extrémités du capteur, sont utilisées pour soumettre le capteur à une tension de référence, ce qui provoque un écoulement de courant d'alimentation dans la couche active entre ces électrodes. Les deux autres électrodes, dites de "mesure", sont disposées à deux autres extrémités du capteur selon un axe perpendiculaire à la direction d'écoulement du courant d'alimentation.

Lorsque le capteur est soumis à un champ magnétique selon une direction perpendiculaire au plan défini par les axes reliant les paires d'électrodes, le capteur délivre entre les électrodes de mesure une tension dite "de Hall" proportionnelle au produit de l'intensité du courant d'alimentation et de l'amplitude du champ magnétique.

La jonction p-n limite normalement la dissipation des porteurs de charge dans le substrat. Mais on constate que la dissipation des porteurs de charge augmente avec l'accroissement de la température créant ainsi un courant de fuite dans le substrat.

Approximativement, on évalue que l'intensité du courant de fuite dans le silicium (Si) est multipliée par deux pour chaque accroissement de sept degrés Celsius de la température. La présence de ce courant de fuite perturbe la mesure et pour obtenir un capteur suffisamment précis peut être utilisable dans le domaine du comptage de la consommation d'électricité, il est usuel de compenser les dérives dues aux variations de température en effectuant une calibration et en utilisant un circuit électronique de compensation.

Mais cette électronique sophistiquée entraîne un surcoût du capteur et, de plus, consomme de l'énergie engendrant ainsi d'autres problèmes liés à son alimentation électrique.

Le document US 5,679,973 décrit un grand nombre de structures possibles pour un élément de Hall latéral. Dans certains exemples de réalisation, la couche active de conductivité de type n est formée entre deux couches en SiO₂. La couche active est de plus entourée par une couche d'isolation latérale formant une jonction p-n avec la couche active.

Les structures de capteur à effet Hall connues, et en particulier celles décrites dans le document US 5,579,973, présentent une couche active épaisse, c'est à dire possédant une épaisseur de l'ordre de quelques micromètres. De plus, l'Homme du Métier possède un fort préjugé le conduisant à penser que la couche active doit présenter une épaisseur minimale de 0,5 micromètre, une épaisseur inférieure conduisant selon ce préjugé à des effets surfaciques de diffusion ("scattering" en terminologie anglo-saxonne) entre la couche active et la couche isolante réduisant leur mobilité (voir par exemple US 5,579,973 description des figures 11 à 14―sixième mode de réalisation).

Le but de la présente invention est de proposer une structure de capteur à effet Hall peu sensible aux variations de température et par conséquent permettant de simplifier le circuit de compensation ou même de s'en passer.

De manière plus précise, la présente invention concerne un capteur à effet Hall comprenant une couche d'isolation en SiO₂, une couche active mince en Si présentant une épaisseur inférieure à 100 nm et recouvrant la couche d'isolation, et une couche diélectrique isolante recouvrant la couche active.

Cette structure possède une forte sensibilité au champ magnétique et une faible dépendance aux variations de température.

Avantageusement, la couche active présente une concentration surfacique de porteurs comprise entre 5.10¹¹ et 10¹³ porteurs/cm².

Préférentiellement, un gaz d'électrons quasi-bidimensionnel est formé dans la couche active.

Selon un mode particulier de réalisation, la concentration de proteurs choisie est obtenue par implantation de donneurs dans la couche active.

Selon un autre mode particulier de réalisation, la concentration de porteurs choisie est obtenue par application d'une différence de potentiels entre la couche active et un substrat sur lequel repose la couche d'isolation.

En variante, la concentration de porteurs choisie est obtenue par application d'une différence de potentiels entre la couche active et une électrode de garde recouvrant la couche diélectrique isolante.

Selon un mode particulier de réalisation, la couche diélectrique isolante est en silice, par exemple SiO₂.

La couche diélectrique isolante peut aussi présenter une composition variable en fonction de son épaisseur afin de réduire les contraintes thermo-mécaniques exercées sur la couche active.

Avantageusement, la couche diélectrique isolante présente une épaisseur supérieure à 10 nm.

Selon un mode de réalisation particulier, la couche d'isolation présente une épaisseur comprise entre 100 nm et 2000 nm.

La présente invention concerne aussi un circuit intégré comprenant un tel capteur et un ou plusieurs composants électroniques associés, le capteur et les composants étant réalisés sur le même substrat.

L'invention sera mieux comprise à la lecture de la description qui suit , donnée à titre explicatif et non limitatif en référence aux dessins annexés sur lesquels :
- La figure 1 est une vue schématique en coupe d'un capteur conforme à l'invention ;
- La figure 2 est une vue schématique en perspective d'un circuit intégrant le capteur.

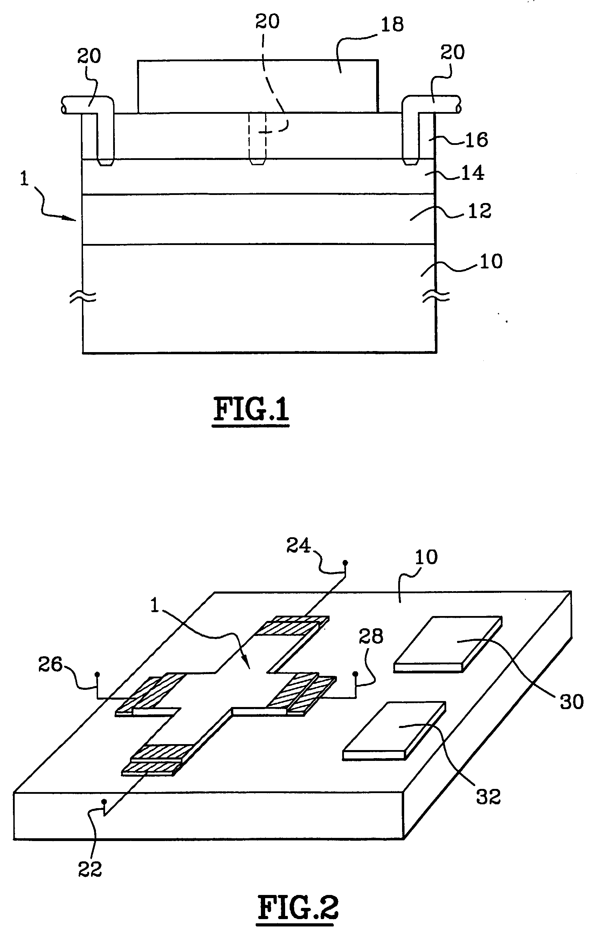

La structure d'un capteur à effet Hall selon l'invention va maintenant être décrite en référence à la figure 1 qui pour des raisons de clarté n'est pas à l'échelle.

Sur la figure 1, un substrat 10 est représenté, mais dans certains cas, une fois le capteur réalisé, ce substrat peut être éliminé.

Le substrat 10 peut être en Si, en verre ou tout autre matériau adéquat. Une couche d'isolation 12 en SiO₂ repose sur le substrat 10. Elle présente une épaisseur comprise entre 100 et 2000 nm, par exemple égale à 400 nm.

Une couche active mince 14 en Si repose sur la couche d'isolation 12. D'une manière générale, l'interface Si/SiO₂ peut être obtenue quasiment sans la présence de pièges ou d'impuretés entraînant la diffusion des porteurs, ce qui collabore à l'obtention des bonnes caractéristiques du capteur.

La couche active 14 présente une épaisseur inférieure ou égale à 100 nm, par exemple comprise entre 5 et 80 nm. Elle peut être égale à 20 nm.

Une couche diélectrique isolante 16 recouvre la couche active 14. Cette couche 16 peut être en silice et par exemple en SiO₂ ou en oxynitrure de silicium éventuellement fluoré ou hydrogéné. Afin de réduire les contraintes thermo-mécaniques, la composition de la couche 16 peut être variable en fonction de son épaisseur avec par exemple une première sous-couche en SiO₂ en contact avec la couche active 14, puis une couche en Si₂N₄ ou encore une alternance de sous-couches Si₂N₄/SiO₂.

La couche isolante diélectrique 16 présente une épaisseur au moins égale à 10 nm.

La couche active 14 présente une concentration surfacique de porteurs de charge comprise entre 5.10¹¹ et 10¹³ porteurs/cm².

Les porteurs de charge sont préférentiellement choisis de type n. La concentration surfacique est alors préférentiellement choisie de manière à réaliser un gaz d'électrons quasi-bidimensionnel dans la couche active 14.

Pour obtenir cette concentration surfacique, la couche active 14 peut être dopée ou non. Le dopage est effectué par implantation de donneurs.

Si elle n'est pas dopée, les porteurs sont créés par l'application d'une différence de potentiels adéquate entre la couche active 14 et le substrat 10. En variante, les porteurs peuvent être créés par l'application d'une différence de potentiels adéquate entre la couche active et une électrode de garde 18 recouvrant la couche diélectrique isolante 16.

L'électrode de garde 18 peut être réalisée en métal ou en siliciure ( PtSi, NiSi, TiSi, Wsi, ...) ou encore en silicium polycristallin. Elle présente une épaisseur au moins égale à 15 nm, par exemple à 50 nm.

Des effets de "pincement" ou de modulation de charges parasites peuvent limiter la stabilité du capteur. Cette électrode de garde 18 permet d'éviter ces effets. L'électrode de garde peut par exemple être connectée au point milieu de la couche active 14 ce qui permet d'obtenir un potentiel sensiblement égal à l'emplacement des électrodes de Hall. Selon un autre montage, l'électrode de garde 18 peut être reliée aux électrodes de Hall par des amplificateurs-suiveurs. Ces techniques connues de l'Homme du Métier ne nécessitent pas de description approfondie.

Des évidements sont percés dans la couche diélectrique isolante 16 de manière à permettre le passage des électrodes 20 en contact avec la couche active 14 dopée n+ aux emplacements des contacts. Bien entendu, l'électrode de garde 18 est réalisée de telle manière que tout contact avec les électrodes 20 est évité.

Une couche de passivation non représentée recouvre l'ensemble et assure sa protection.

La fabrication du capteur à effet Hall 1 peut être réalisée selon le procédé suivant. Des plaquettes Si/SiO₂/Si comportant donc le substrat, la couche isolante et la couche qui après traitement deviendra la couche active, peuvent être obtenues par les procédés connus sous les désignations SIMOX, SMART CUT (marque déposée) ou UNIBOND (marque déposée) avec les épaisseurs de couches requises. Ces procédés sont usuellement utilisés pour la réalisation de microcircuits basse tension/basse consommation, notamment ceux alimentés par pile dans des applications de télécommunication.

L'interface entre couche active et couche isolante de ces plaquettes est quasiment exempte d'impureté risquant de piéger les porteurs de charge et par suite de dégrader les caractéristiques du capteur.

Pour obtenir le capteur à effet Hall, les opérations suivante sont réalisées sur ces plaquettes.

La couche active est sculptée selon un procédé d'amincissement par exemple oxydation, gravure chimique sèche ou humide. La concentration de porteurs souhaitée dans la couche active est par exemple obtenue par implantation ionique ou comme déjà mentionné par application d'un champ électrique adéquat. La couche diélectrique isolante est ensuite obtenue par exemple par oxydation, dépôt de type CVD ou pulvérisation cathodique.

Les électrodes sont réalisées par un quelconque procédé de micro-électronique adapté au couches SOI (abréviation usuelle de l'expression anglaise Silicon on Insulator, soit Silicium sur Isolant) puis reliées à des connexions. L'électrode de garde peut être réalisée par exemple par un procédé CVD ou par évaporation.

Selon un mode de réalisation usuel pour les capteurs à effet Hall et que l'on peut voir sur la figure 2, le capteur 1 présente une forme de croix, une électrode étant disposée à chaque extrémité de la croix.

Les électrodes sont reliées à des connexions 22, 24, 26, 28. Les connexions 22, 24 en vis à vis permettent la mesure de la tension de Hall lorsqu'un champ magnétique est appliqué perpendiculairement au plan engendré par les axes passant par chacun des couples d'électrodes.

De manière avantageuse, les composants électroniques associés au capteur à effet Hall sont réalisés sur la même plaquette Si/SiO₂/Si que le capteur et sont donc placés à courte distance sur le même substrat. Ces composants peuvent comprendre notamment le circuit d'amplification du signal de Hall, la chaîne associée au convertisseur ou aux convertisseurs de type sigma-delta utilisée pour traiter le signal de mesure issu du capteur, la source de tension de référence, ... Ils sont représentés symboliquement sur la figure 2, sans toutefois les connexions qui les relient au capteur 1, et portent les références 30 et 32.

L'ensemble forme donc un circuit intégré qui, dans le cas du comptage d'une consommation d'électricité est à même de délivrer un signal numérique représentatif de la puissance électrique ou du courant électrique consommé.

Le capteur à effet Hall selon l'invention est donc peu sensible aux effets thermiques et aux non-linéarités dues aux fuites de courant. La couche active peut être très mince et contenir une très forte concentration de porteurs de charge. Elle est limitée par des couches non-conductrices épaisses, ce qui réduit les non-linéarités dues au phénomène de pincement. Ce phénomène peut être encore diminué par l'ajout d'une électrode de garde. De plus, grâce à la possibilité de réaliser ce capteur par des technologies mises en oeuvre pour la réalisation d'autres composants semi-conducteurs, des circuits intégrés complets peuvent être fabriqués.

La forme en croix et le nombre d'électrodes du capteur décrites présentement ne sont données qu'à titre illustratif car tout en restant dans le cadre de l'invention, le capteur peut prendre des formes diverses comme par exemple une forme carrée, ou selon une structure Van der Pauw ou encore en forme de croix à six électrodes.

## Revendications

1. Capteur à effet Hall caractérisé en ce qu'il comprend :
- Une couche d'isolation (12) en SiO₂;
- Une couche active mince (14) en Si recouvrant la couche d'isolation (12) et présentant une épaisseur inférieure à 100 nm ;
- Une couche diélectrique isolante (16) recouvrant la couche active (14).

2. Capteur à effet Hall selon la revendication 1 dans lequel la couche active (14) présente une concentration surfacique de porteurs comprise entre 5.10¹¹ et 10¹³ porteurs/cm².

3. Capteur à effet Hall selon la revendication 2, dans lequel un gaz d'électrons quasi-bidimensionnel est formé dans la couche active (14).

4. Capteur à effet Hall selon l'une quelconque des revendications 2 ou 3 dans lequel la concentration surfacique de porteurs choisie est obtenue par implantation de donneurs dans la couche active (14).

5. Capteur à effet Hall selon l'une quelconque des revendications 2 ou 3 dans lequel la concentration surfacique de porteurs choisie est obtenue par application d'une différence de potentiels entre la couche active (14) et un substrat (10) sur lequel repose la couche d'isolation (12).

6. Capteur à effet Hall selon l'une quelconque des revendications 2 ou 3 dans lequel la concentration surfacique de porteurs choisie est obtenue par application d'une différence de potentiels entre la couche active (14) et une électrode de garde (18) recouvrant la couche diéletrique isolante (16).

7. Capteur à effet hall selon l'une quelconque des revendications précédentes, dans lequel la couche diélectrique isolante (16) est en silice.

8. Capteur à effet Hall selon la revendication 7, dans lequel la couche diélectrique isolante (16) est en SiO₂.

9. Capteur à effet Hall selon la revendications 7, dans lequel la couche diélectrique isolante (16) présente une composition variable en fonction de son épaisseur.

10. Capteur à effet Hall selon l'une quelconque des revendications précédentes, dans lequel la couche diélectrique isolante (16) présente une épaisseur supérieure à 10 nm.

11. Capteur à effet Hall selon l'une quelconque des revendications précédentes, dans lequel la couche d'isolation (12) présente une épaisseur comprise entre 100 nm et 2000 nm.

12. Circuit intégré caractérisé en ce qu'il comprend un capteur à effet Hall (1) selon l'une quelconque des revendications précédentes et des composants électroniques associés (30, 32), le capteur (1) et les composants (30, 32) étant réalisés sur un même substrat (10).
